# EUROPEAN PATENT SPECIFICATION

(11) **EP 3 648 168 B1**
(45) Date of publication and mention of the grant of the patent: **20.03.2024**
(21) Application number: 18825345.4
(22) Date of filing: 23.05.2018
(51) Int. Cl.: H10K 59/121, H01L 27/02, H01L 21/77, G09G 3/3225, H10K 59/131, G09G 3/3266

(54) **ORGANIC ELECTROLUMINESCENT DISPLAY PANEL AND MANUFACTURING METHOD THEREFOR, AND DISPLAY DEVICE**
ORGANISCHE ELEKTROLUMINESZENTE ANZEIGETAFEL UND HERSTELLUNGSVERFAHREN DAFÜR SOWIE ANZEIGEVORRICHTUNG
ÉCRAN D'AFFICHAGE ÉLECTROLUMINESCENT ORGANIQUE, SON PROCÉDÉ DE FABRICATION ET DISPOSITIF D'AFFICHAGE

(30) Priority: 29.06.2017 CN 201710516966
(43) Date of publication of application: 06.05.2020
(60) Divisional application: 24150369.7
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: KO, Youngyik, Beijing 100176 (CN); TAN, Wen, Beijing 100176 (CN); HUANG, Weiyun, Beijing 100176 (CN); WANG, Benlian, Beijing 100176 (CN)
(74) Representative: Gesthuysen Patentanwälte
(86) International application number: PCT/CN2018/087965
(87) International publication number: WO 2019/001177

(56) References cited:
- CN-A- 105 405 865
- CN-A- 106 097 968
- CN-A- 106 782 416
- CN-A- 106 782 416
- CN-U- 206 947 350
- JP-B2- 4 646 951
- US-A1- 2011 248 968
- US-A1- 2014 184 479
- US-A1- 2017 154 943

## Description

### RELATED APPLICATION(s)

The present application claims the benefit of Chinese Patent Application No. 201710516966.4, filed on June 29, 2017.

### TECHNICAL FIELD

The present disclosure relates to the field of display technology, and discloses specifically an organic electroluminescence display panel, a fabricating method thereof, and a display device.

### BACKGROUND

In a conventional display panel, the display area is generally located in the middle of panel, and the gate driving circuit is located near the frame of panel. In this way, adverse effects on the display area due to the gate driving circuit are avoided. However, such an arrangement of gate driving circuit at the frame tends to result in display panels and subsequent display products with wider frames.

Therefore, with the increasing popularity of narrow frames and even frameless designs, it has been proposed to move the gate driving circuit from the frame area to the display area, for example, into the pixel area, so as to narrow down and even eliminate the frame. However, in a specific implementation, it is extremely difficult to dispose a gate driving circuit in the display. For OLED products, especially high-resolution OLED products, it is very difficult to dispose further the gate driving circuit in a limited display area, since the complicated pixel driving circuit has been disposed in the same display area.

Document D1(CN106782416A) discloses a display panel and a display device. The display panel comprises a substrate comprising a display area and a non-display area, a scanning driving circuit located in the display area, multiple gate lines and multiple data lines. The multiple gate lines and the multiple data lines are insulated and intersected to define multiple pixel circuit units. The pixel circuit units comprise first pixel circuit units and second pixel circuit units, the first pixel circuit units are arranged in array to form a first pixel circuit array, and the second pixel circuit units are arranged in array to form a second pixel circuit array. The width of the first pixel circuit units is smaller than that of the second pixel circuit units in the extending direction of the gate lines. The width of the first pixel circuit units in the extending direction of the gate lines is smaller, so that a part of area in the display area is vacated, the scanning driving circuit is arranged in the vacated area, that is, the scanning driving circuit is arranged in the display area, the area of the non-display area is saved, and the narrow bezel is obtained.

Document D2 (US2017/154943A1) discloses an array substrate, a manufacturing method thereof, and a display device. The array substrate comprises: a base substrate; plural light emitting units disposed on the base substrate to constitute a light emitting region, a display region driving circuit electrically connected to the plural light emitting units; and a peripheral circuit disposed at a periphery of the display region driving circuit, at least one light emitting unit is located on the peripheral circuit, and an orthographic projection of the at least one light emitting unit on the base substrate and an orthographic projection of the peripheral circuit on the base substrate have an overlapping portion there-between. Document D3 (CN106097968A) discloses a display panel and a display device. The display panel comprises a display area. An array substrate on driver circuit is formed on the display area. Through formation of the GOA circuit on the display area, the problem that a frame of the display device is still large because the GOA circuit arranged at the peripheral region still occupies a certain area although the frame of the manufactured display device is shrunk through the GOA circuit in the relevant technology to a certain extent is solved. An area originally used for forming the GOA is not reserved in the peripheral region of the display panel, and the effect that the display device frame supported by the display panel is small is achieved.

Document D4(CN105405865A) relates to an AMOLED display and a pixel arrangement method. An OLED pixel array including a plurality of pixels, a thin film transistor array including a plurality of thin film transistors and a GIP circuit are arranged on a substrate; the GIP circuit is distributed at the outer side of the thin film transistor array; the OLED pixel array completely covers the thin film transistor array and the GIP circuit. The pixels of the OLED pixel array are in one-to-one correspondence connection with the thin film transistors; and therefore, the OLED pixel array can shield the GIP circuit below the thin film transistor array, and the display region of the AMOLED display can be expanded, and a space occupied by the shielding ring can be decreased, and at the same time, the higher the resolution is, the higher the number of the pixels is, and the better the shielding effect is. With the AMOLED display and the pixel arrangement method adopted, a narrow border design can be realized under high resolution.

Document DS(US2011/248968A1) discloses a flat panel display device having a reduced dead space. The flat panel display device includes a pixel unit having a plurality of pixels, and a built-in circuit unit in which a driver circuit for driving the pixels is formed. In the flat panel display device, the built-in circuit unit is disposed to partially overlap with the pixel unit.

Document D6(US2014/184479A1) relates to an organic light emitting diode device and a display apparatus corresponding thereto. The organic light emitting diode device comprises a plurality of pixels. Each pixel comprises an organic light emitting unit and a driving unit. The organic light emitting unit is disposed in a displaying region. The driving unit is disposed in a driving region. The driving region overlaps the displaying region and the driving region is smaller than the displaying region. According to the organic light emitting diode device and corresponding display apparatus of the present invention, it is easier to fulfill the organic light emitting diode device with narrow bezel.

### SUMMARY

According to an aspect of the present disclosure, an embodiment provides an organic electroluminescence display panel. The organic electroluminescence display panel comprises: a base substrate having a display area; a gate driving circuit; a plurality of data lines in the display area; and a plurality of pixel driving circuits located in the display area; and a plurality of top emission type of light-emitting units located in the display area. Further, in the above organic electroluminescence display panel, an orthographic projection of the gate driving circuit on the base substrate at least partially overlaps with an orthographic projection of the plurality of top emission type of light-emitting units on the base substrate. Each of at least some of the plurality of pixel driving circuits is configured to drive at least two top emission type of light-emitting units of the plurality of top emission type of light-emitting units, and the plurality of top emission type of light-emitting units span over the plurality of data lines, such that all circuits comprising the gate driving circuit and the plurality of pixel driving circuits in the display area are covered by the plurality of top emission type of light-emitting units.

According to a possible implementation, in the above organic electroluminescence display panel provided by an embodiment of the present disclosure, the orthogonal projection of the gate driving circuit on the base substrate does not overlap with an orthogonal projection of the plurality of pixel driving circuits on the base substrate.

According to a possible implementation, in the above organic electroluminescence display panel provided by an embodiment of the present disclosure, each of the top emission type of light-emitting units comprises an anode, a light-emitting layer and a cathode that are sequentially stacked, wherein the anode is connected to a respective pixel driving circuit.

According to a possible implementation, in the above organic electroluminescence display panel provided by an embodiment of the present disclosure, the anode of each of the top emission type of light-emitting units is connected to a respective pixel driving circuit by a connection line.

According to a possible implementation, in the above organic electroluminescence display panel provided by an embodiment of the present disclosure, the connection line is located between a first film layer where the respective top emission type of light-emitting unit is located and a second film layer where the respective pixel driving circuit is located.

According to a possible implementation, in the above organic electroluminescence display panel provided by an embodiment of the present disclosure, the gate driving circuit is located at an edge of the display area of the base substrate.

According to a possible implementation, in the above organic electroluminescence display panel provided by an embodiment of the present disclosure, the gate driving circuit comprises a gate sub-driving circuit located at an edge of the display area of the base substrate. Alternatively, in other implementations, the gate driving circuit comprises a first gate sub-driving circuit and a second gate sub-driving circuit located respectively at two opposite edges of the display area of the base substrate.

According to a possible implementation, in the above organic electroluminescence display panel provided by an embodiment of the present disclosure, the gate driving circuit is located between two adjacent pixel driving circuits.

According to another aspect of the present disclosure, an embodiment further provides a display device, comprising the above organic electroluminescence display panel according to embodiments of the present disclosure.

According to yet another aspect of the present disclosure, an embodiment further provides a fabricating method for the above organic electroluminescence display panel. The fabricating method comprises steps of: fabricating a gate driving circuit and a plurality of pixel driving circuits in a display area of a base substrate, wherein an orthogonal projection of the gate driving circuit on the base substrate does not overlap with an orthogonal projection of the plurality of pixel driving circuits on the base substrate; and fabricating further a plurality of top emission type of light-emitting units in the display area of the base substrate, wherein the plurality of top emission type of light-emitting units at least partially cover the plurality of pixel driving circuits and the gate driving circuit, and an orthographic projection of the gate driving circuit on the base substrate at least partially overlaps with an orthographic projection of the plurality of top emission type of light-emitting units on the substrate.

According to a possible implementation, in an embodiment of the present disclosure, the method of fabricating the above organic electroluminescence display panel also comprises steps of: after fabricating the gate driving circuit and the plurality of pixel driving circuits in the display area of the base substrate, and before fabricating further the plurality of top emission type of light-emitting units in the display area of the base substrate, fabricating connection lines, wherein the connection lines are configured to connect respectively an anode of each of the top emission type of light-emitting units to a respective pixel driving circuit.

### BRIEF DESCRIPTION OF THE DRAWINGS

Fig. 1 is a schematic structural diagram of a display panel according to a conventional approach;
Fig. 2 is a schematic diagram showing a circuit structure of a shift register in the display panel of Fig. 1;
Fig. 3 is a schematic diagram showing a circuit structure of a shift register located in a display area according to another conventional approach;
Figs. 4-6 are respectively schematic structural diagrams of organic electroluminescence display panels according to embodiments of the present disclosure; and
Fig. 7 schematically shows a simplified cross-sectional view of a hierarchical relationship between a connection line, a top emission type of light-emitting unit, and a pixel driving circuit in an organic electroluminescence display panel according to an embodiment of the present disclosure.

### DETAILED DESCRIPTION OF THE DISCLOSURE

Specific implementations of the organic electroluminescence display panel, the fabricating method thereof and the display device provided by embodiments of the present disclosure will be described in detail below with reference to the accompanying drawings.

It should be noted that the thickness and shape of various film layers in the drawings do not represent any real proportion in the organic electroluminescence display panel, and are merely intended to illustrate the present disclosure.

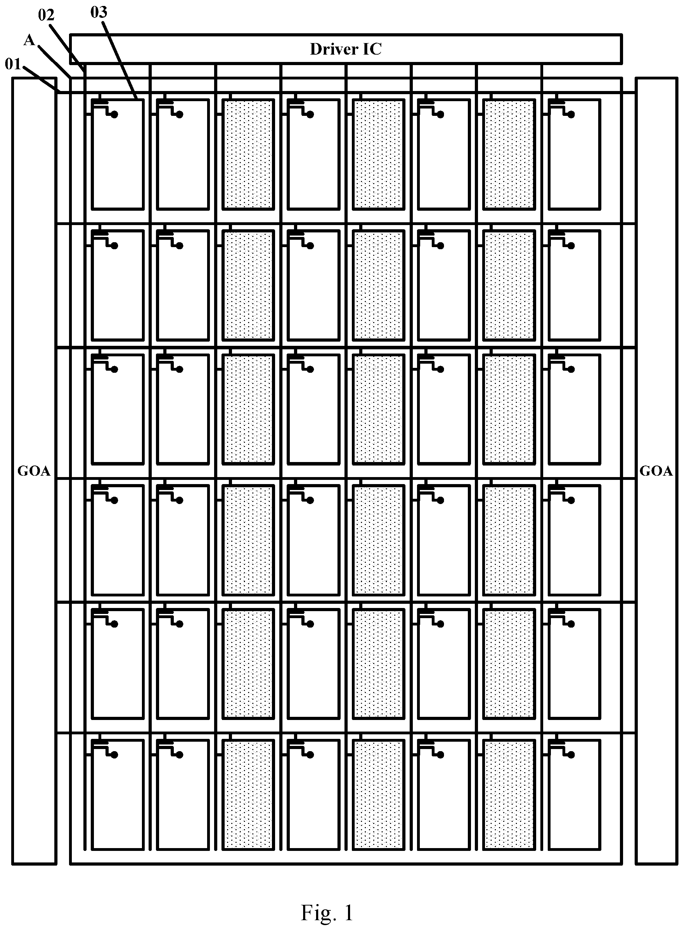

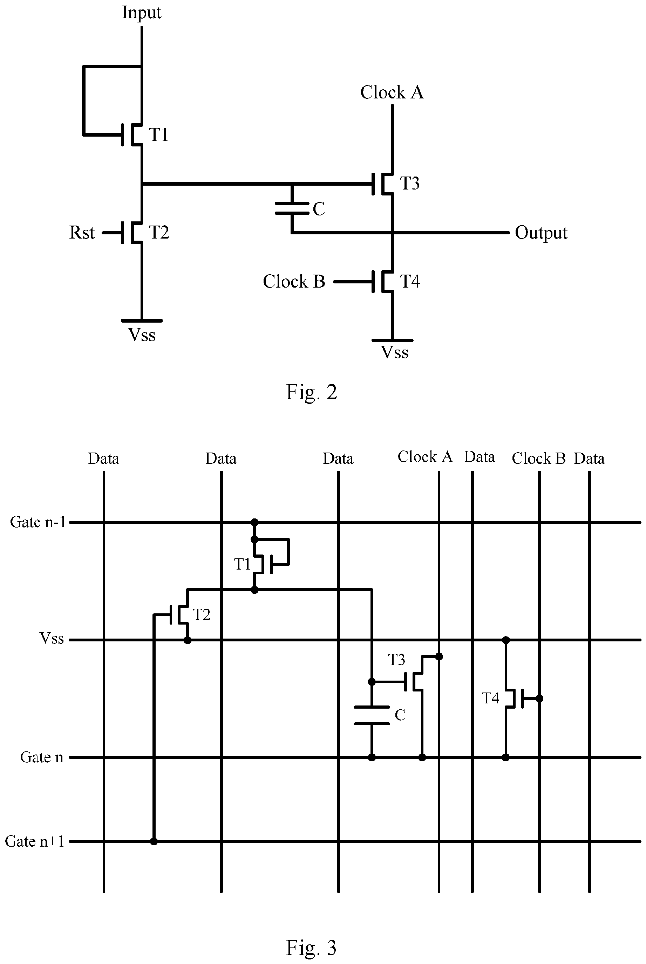

As shown in Fig. 1, according to a conventional approach, a gate line 01, a data line 02, and a pixel unit 03 are disposed in a display area A of a display panel, wherein the pixel unit is disposed in an area defined by the gate line 01 and the data line 02. Also, a gate driving circuit for driving the gate line 01 is provided at the left and right frames. Specifically, the gate driving circuit consists of a plurality of cascaded shift registers, wherein each shift register is composed of at least four switching transistors T1, T2, T3, and T4, and a circuit structure diagram thereof is shown in Fig. 2.

As mentioned above, for the purpose of narrowing down the frame of display panel and even realizing a frameless design, it has been proposed to use the approach as shown in Fig. 3, in which the gate driving circuit that was located otherwise in the frame area is moved now to the pixel area. In this way, the space for disposing the gate driving circuit at the frame is eliminated, thereby realizing an ultra-narrow frame or even a frameless design. However, in actual operations, it is difficult to dispose a gate driving circuit in the display area. In particular, for OLED products, the difficulty is further increased, because in OLED products, especially in high-resolution OLED products, complex pixel circuits have already been disposed in the size-limited display area.

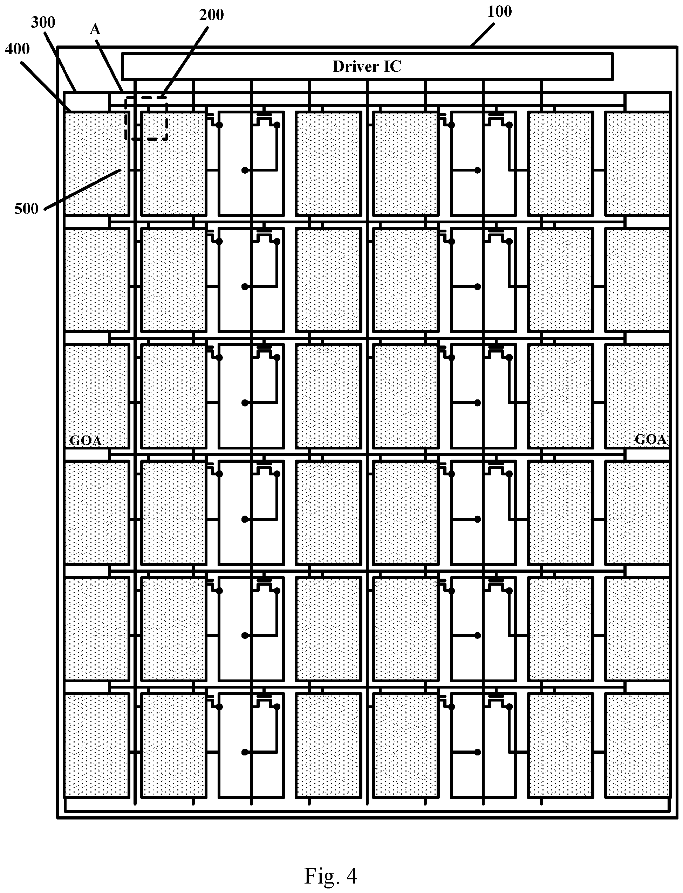

As shown in Figs. 4-6, the organic electroluminescence display panel comprises: a base substrate 100; a plurality of pixel driving circuits 200 and a gate driving circuit 300 disposed in the display area A of the base substrate 100; and a plurality of top emission type of light-emitting units 400 disposed in the display area A of the base substrate 100 and covering the plurality of pixel driving circuits 200 and the gate driving circuit 300. Further, an orthographic projection of the gate driving circuit 300 on the base substrate 100 does not overlap with an orthographic projection of the plurality of pixel driving circuits 200 on the base substrate 100. Besides, the orthographic projection of the gate driving circuit 300 on the base substrate 100 at least partially overlaps with an orthographic projection of the plurality of top emission type of light-emitting units 400 on the base substrate 100.

Specifically, in the above organic electroluminescence display panel provided by an embodiment of the present disclosure, the gate driving circuit 300 and the pixel driving circuits 200 are simultaneously disposed in the display area A of the base substrate 100, and also it is ensured that the orthographic projection of the gate driving circuit 300 on the base substrate 100 does not overlap with the orthographic projection of the pixel driving circuits 200 on the base substrate 100. That is, the switching transistors in the gate driving circuit 300 are not disposed inside the pixel driving circuit 200 as in Fig. 3, and thus will not occupy the wiring space of the pixel driving circuit 200. Therefore, it is ensured that both of the gate driving circuit 300 and the pixel driving circuit 200 have sufficient wiring spaces in the display area.

Meanwhile, in the above organic electroluminescence display panel provided by an embodiment of the present disclosure, a plurality of top emission type of light-emitting units 400, which is covering the pixel driving circuits 200 and the gate driving circuit 300, are further disposed in the display area A of the base substrate 100. In such a case, according to an embodiment of the present disclosure, the area occupied by each of the top emission type of light-emitting units is increased as compared with the conventional pixel unit (corresponding to the top emission type of light-emitting unit 400). Specifically, in the conventional approach, one of the top emission type of light-emitting units 400 only overlaps with one of the pixel driving circuits 200. That is, the conventional top emission type of light-emitting unit 400 is disposed in a region defined by the gate line and the data line. However, according to an embodiment of the present disclosure, the gate driving circuit 300 has an overlapping region with the top emission type of light-emitting units 400 in the display area A. That is, according to the present invention, the top emission type of light-emitting units 400 span over the data lines, thereby ensuring that all circuits in the display area A are covered by the top emission type of light-emitting units 400. In this way, it is ensured that both of the gate driving circuit 300 and the pixel driving circuits 200 have sufficient wiring spaces in the display area A, thereby eliminating the need for arranging the gate driving circuit 300 at the frame, and thus realizing an ultra-narrow frame or even a frameless design.

According to a specific embodiment, in the above organic electroluminescence display panel provided by an embodiment of the present disclosure, each of the top emission type of light-emitting units 400 comprises generally an anode, a light-emitting layer, and a cathode that are sequentially stacked, wherein the anode is connected to a respective pixel driving circuit 200. In order to ensure light emission from the cathode side of each of the top emission type of light-emitting units 400, it is required that the cathode is made of light transmissive material. However, the anode may be generally fabricated by an opaque metal, or a reflective layer can be fabricated separately under a transparent anode. In addition, the top emission type of light-emitting unit 400 may further comprise a functional film layer, such as an electron transport layer, a hole transport layer, an electron blocking layer, and a hole blocking layer, and the present disclosure is not limited in this regard.

According to a specific embodiment, in the above organic electroluminescence display panel provided by an embodiment of the present disclosure, in order to ensure that light-emitting regions are distributed uniformly in the display area A, as shown in Figs. 4-6, anodes of each of the top emission type of light-emitting units 400 may be distributed uniformly in the display area A of the base substrate 100. That is, intervals between anodes of the top emission type of light-emitting units 400 keep the same.

According to a specific embodiment, in the above organic electroluminescence display panel provided by an embodiment of the present disclosure, in order to ensure that light-emitting regions are distributed uniformly in the display area A, as shown in Figs. 4-6, anodes of the top emission type of light-emitting units 400 can be configured to be the same in shape and size. Alternatively, when each of the top emission type of light-emitting units 400 is fabricated using a single color light-emitting layer, the light-emitting efficiency may be different depending on the material of the light-emitting layer in each of the top emission type of light-emitting units 400. Therefore, in a specific embodiment, it is also possible to set the area occupied by the light-emitting layer and the anode in each of the top emission type of light-emitting units 400 based on the light-emitting efficiency. That is, the area occupied by the top emission type of light-emitting unit 400 having high light-emitting efficiency is relatively small, and the area occupied by the top emission type of light-emitting unit 400 having low light-emitting efficiency is relatively large.

According to a specific example not forming part of the present invention but being useful to understand it, as shown in Figs. 4-6, each of the top emission type of light-emitting units 400 is corresponding to a respective one of the pixel driving circuits 200, so as to drive the top emission type of light-emitting units 400 in a better way to emit light. That is, one pixel driving circuit 200 drives one of the top emission type of light-emitting units 400 to emit light. In the present invention, however, one pixel driving circuit 200 drives a plurality of top emission type of light-emitting units 400 to emit light. In this case, since the area occupied by the top emission type of light-emitting unit 400 is increased, there may be a case where the top emission type of light-emitting unit 400 and its respective pixel driving circuit 200 do not directly overlap with each other. That is, for example, referring to Fig. 4, the top emission type of light-emitting units 400 in the leftmost column has an overlapping region only with the gate driving circuit 300. In view of above, as shown in Figs. 4-6, anodes of each of the top emission type of light-emitting units 400 need to be connected to their respective pixel driving circuits 200 by respective connection lines 500.

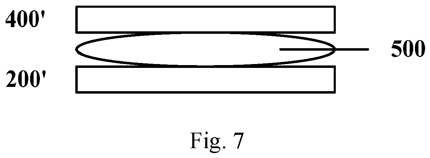

According to a specific embodiment, in the above organic electroluminescence display panel provided by an embodiment of the present disclosure, the connection lines 500 may be disposed in an existing conductive film layer, for example, disposed in the same layer as the gate lines, so as to reduce process steps. However, this will increase the complexity for wiring in the film. In view of above, advantageously, in the above organic electroluminescence display panel provided by an embodiment of the present disclosure, the connection lines 500 can be provided as a separate film layer. For example, referring to Fig. 7, which is a schematic diagram showing a hierarchical relationship between a connection line 500, a top emission type of light-emitting unit 400, and a pixel driving circuit 200 in an organic electroluminescence display panel according to an embodiment of the present disclosure. Specifically, the connection line 500 may be disposed between a first film layer 400' where the top emission type of light-emitting unit 400 is located and a second film layer 200' where the pixel driving circuit 200 is located. This means that in the above embodiment, the film layers to be patterned in the fabricating process of the organic electroluminescence display panel are respectively: active layer-*gate insulating layer-*gate metal layer→interlayer insulating layer→source-drain metal layer-*planarization layer→anode→pixel defining layer-*spacer layer. In contrast, for the organic electroluminescence display panel provided by embodiments of the present disclosure, two additional film layers are needed in the fabricating process. That is, the film layers will change to be respectively: active layer-*gate insulating layer-*gate metal layer→interlayer insulating layer→source-drain metal layer→insulating layer→connection line layer-*planarization layer→anode→pixel defining layer-*spacer layer.

According to a specific embodiment, in the above organic electroluminescence display panel provided by an embodiment of the present disclosure, the specific position for the gate driving circuit 300 in the display area A of the base substrate 100 is not limited, which may be determined based on the actual size of the display panel. For example, as shown in Fig. 4, the gate driving circuit 300 may be disposed at an edge of the display area A of the base substrate 100. Moreover, in the above organic electroluminescence display panel provided by an embodiment of the present disclosure, as shown in Fig. 4, the gate driving circuit 300 may comprise two gate sub-driving circuits, which are respectively disposed at two opposite edges of the display area of the base substrate 100, so as to achieve bilateral driving. In this way, problems such as signal delay in a large-sized panel can be alleviated. Of course, alternatively, the gate driving circuit 300 may be disposed only at any edge of the display area A.

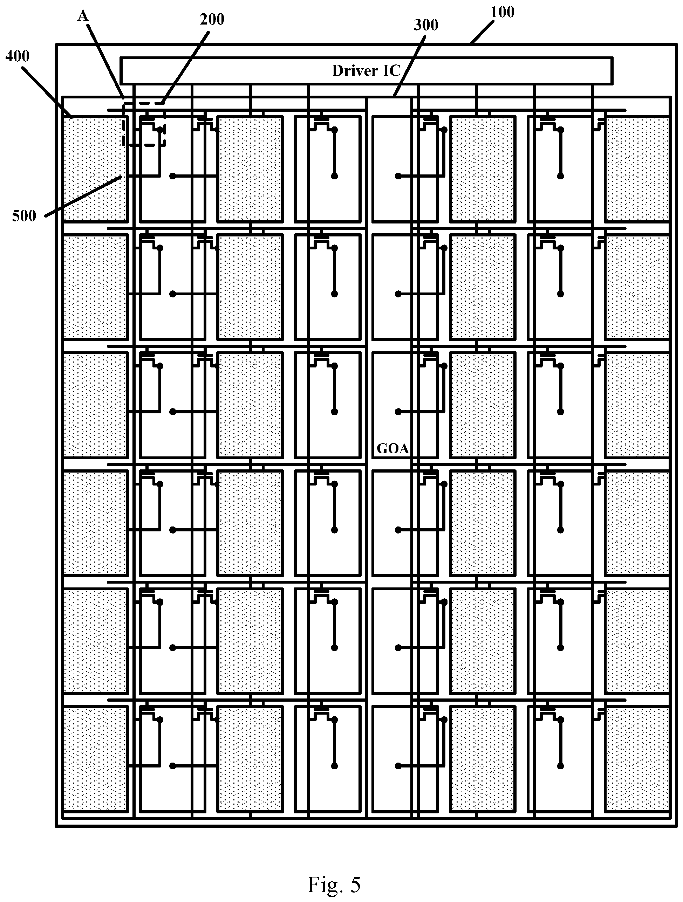

According to a specific embodiment, in the above organic electroluminescence display panel provided by an embodiment of the present disclosure, as shown in Fig. 5, the gate driving circuit 300 may be disposed at a position between two adjacent pixel driving circuits 200. For example, in Fig. 5, the gate driving circuit 300 is disposed at an intermediate position of the display area A. Therefore, driving signals can be supplied at the same time to the gate lines at both sides, thereby contributing to a reduction of signal delay.

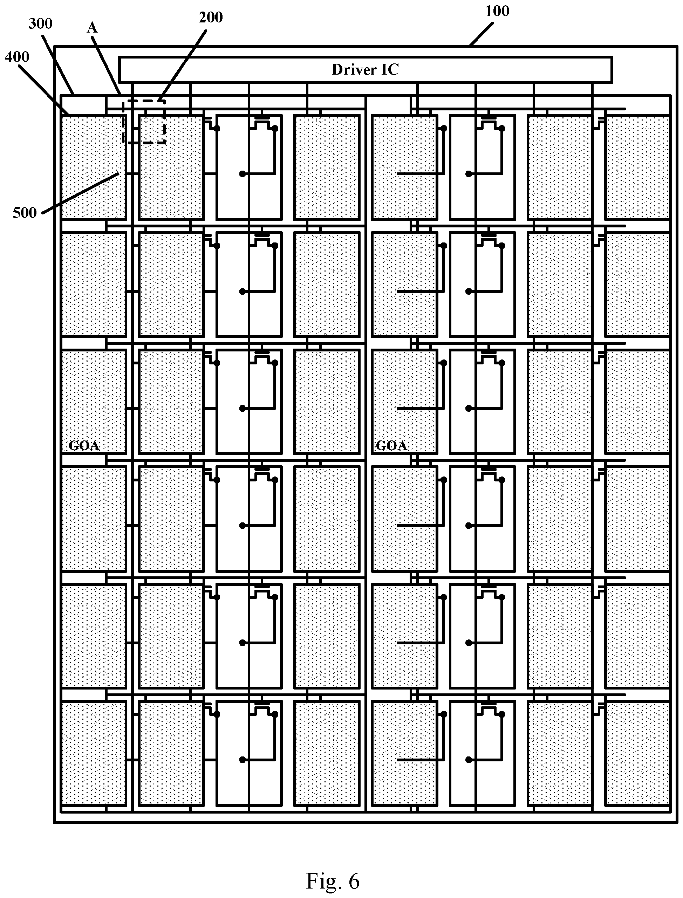

Obviously, the above content is merely for illustrating how to dispose the gate driving circuit 300 in the display area A of the above organic electroluminescence display panel provided by embodiments of the present disclosure, and the present disclosure is not limited thereto. For example, as shown in Fig. 6, a plurality of gate sub-driving circuits may be simultaneously disposed at edge and intermediate position of the display area A, and they constitute together the gate driving circuit 300. Of course, the present disclosure is in no way limited in this respect. Based on the same concept, embodiments of the present disclosure also provide a display device, comprising the organic electroluminescence display panel according to any of the above embodiments of the present disclosure. The display device can be any products or components having a display function, such as a mobile phone, a tablet computer, a television set, a display, a notebook computer, a digital photo frame, a navigator, and the like. For specific implementations of the display device, reference may be made to the embodiments of the above organic electroluminescence display panel, and the repeated description is omitted herein.

Based on the same concept, embodiments of the present disclosure also provide a fabricating method for the above organic electroluminescence display panel. The fabricating method comprises the steps of fabricating the display panel of claim 1.

According to a specific embodiment, the above fabricating method provided by embodiments of the present disclosure may also comprise the following optional steps: after fabricating the gate driving circuit and the plurality of pixel driving circuits in the display area of the base substrate, and before fabricating further the plurality of top emission type of light-emitting units in the display area of the base substrate, fabricating connection lines for connecting an anode of each of the top emission type of light-emitting units to a respective pixel driving circuit. For example, in the fabricating method for the organic electroluminescence display panel provided by embodiments of the present disclosure, the film layers to be patterned are respectively: active layer-*gate insulating layer-*gate metal layer→interlayer insulating layer→source-drain metal layer →insulating layer→connection line layer-*planarization layer→anode→pixel defining layer-*spacer layer. The above is merely an example in which a driving circuit is constituted by a top gate transistor. Of course, according to a specific embodiment, the driving circuit can also be fabricated by a bottom gate transistor, which is not limited herein.

Embodiments of the present disclosure provide an organic electroluminescence display panel, a fabricating method thereof, and a display device. Specifically, in the above organic electroluminescence display panel, the gate driving circuit and the pixel driving circuits are simultaneously disposed in the display area of the base substrate. Further, it is also ensured that the orthographic projection of the gate driving circuit on the base substrate does not overlap with the orthographic projection of the pixel driving circuits on the base substrate, thereby providing sufficient wiring spaces for both of the gate driving circuit and the pixel driving circuits in the display area. Further, a plurality of top emission type of light-emitting units at least partially covering the pixel driving circuits and the gate driving circuit are further provided in the display area of the base substrate. Therefore, the area occupied by each of the top emission type of light-emitting units is increased. Those skilled in the art should readily contemplate that in a conventional display panel, one of the top emission type of light-emitting units overlaps only with one of the pixel driving circuits. However, by contrast, in embodiments of the present disclosure, the gate driving circuit in the display area has an overlapping region with the top emission type of light-emitting units, thereby ensuring that all circuits in the display area are covered by the top emission type of light-emitting units. In this way, it is ensured that there are sufficient wiring spaces for the gate driving circuit and the pixel driving circuits in the display area, thereby eliminating the need to provide the gate driving circuit at the frame, and achieving an ultra-narrow frame or even a frameless design.

In all the descriptions herein, the expression of "orthographic projection of A on a base substrate" refers to a projection of A onto the base substrate in a direction perpendicular to the base substrate, which should be readily appreciated by those skilled in the art.

## Claims

1. An organic electroluminescence display panel, comprising:
a base substrate(100) having a display area(A);
a gate driving circuit (300) and a plurality of pixel driving circuits(200) located in the display area(A);
a plurality of data lines in the display area(A); and
a plurality of top emission type of light-emitting units(400) located in the display area(A), wherein
an orthographic projection of the gate driving circuit(300) on the base substrate(100) at least partially overlaps with an orthographic projection of the plurality of top emission type of light-emitting units(400) on the base substrate(100),
**characterized in that**, each of at least some of the plurality of pixel driving circuits(200) is configured to drive at least two top emission type of light-emitting units(400) of the plurality of top emission type of light-emitting units(400), and the plurality of top emission type of light-emitting units(400) span over the plurality of data lines, such that all circuits comprising the gate driving circuit(300) and the plurality of pixel driving circuits(200) in the display area(A) are covered by the plurality of top emission type of light-emitting units(400).

2. The organic electroluminescence display panel according to claim 1,
wherein
the orthogonal projection of the gate driving circuit(300) on the base substrate(100) does not overlap with an orthogonal projection of the plurality of pixel driving circuits(200) on the base substrate(100).

3. The organic electroluminescence display panel according to claim 1,
wherein
the gate driving circuit(300) is located at an edge of the display area(A).

4. The organic electroluminescence display panel according to claim 1,
wherein
the gate driving circuit(300) comprises a gate sub-driving circuit located at an edge of the display area.

5. The organic electroluminescence display panel according to claim 1,
wherein
the gate driving circuit(300) comprises a first gate sub-driving circuit and a second gate sub-driving circuit located respectively at two opposite edges of the display area(A).

6. The organic electroluminescence display panel according to claim 1,
wherein
the gate driving circuit(300) is located between two adjacent pixel driving circuits(200).

7. The organic electroluminescence display panel according to claim 1,
wherein
each of the top emission type of light-emitting units(400) comprises an anode, a light-emitting layer and a cathode that are sequentially stacked, wherein the anode is connected to a respective pixel driving circuits(200).

8. The organic electroluminescence display panel according to claim 7,
wherein
the anode of each of the top emission type of light-emitting units(400) is connected to the respective pixel driving circuits(200) by a connection line(500).

9. The organic electroluminescence display panel according to claim 8,
wherein
the connection line(500) is located between a first film layer where the respective top emission type of light-emitting unit(400) is located and a second film layer where the respective pixel driving circuit(200) is located.

10. A display device comprising the organic electroluminescence display panel according to any of claims 1-9.

11. A method of fabricating the organic electroluminescence display panel according to any of claims 1-9, comprising:
fabricating a gate driving circuit(300) and a plurality of pixel driving circuits(200) in a display area(A) of a base substrate(100), wherein an orthogonal projection of the gate driving circuit(300) on the base substrate(100) does not overlap with an orthogonal projection of the plurality of pixel driving circuits(200) on the base substrate(100); and fabricating further a plurality of top emission type of light-emitting units (400) in the display area(A), wherein the plurality of top emission type of light-emitting units(400) at least partially cover the plurality of pixel driving circuits(200) and the gate driving circuit(300), and the orthographic projection of the gate driving circuit(300) on the base substrate(100) at least partially overlaps with an orthographic projection of the plurality of top emission type of light-emitting units(400) on the base substrate(100).

12. The fabricating method according to claim 11, further comprising:
after fabricating the gate driving circuit (300) and the plurality of pixel driving circuits (200) in the display area (A) of the base substrate (100), and before fabricating further the plurality of top emission type of light-emitting units(400) in the display area(A), fabricating connection lines(500), wherein the connection lines(500) are configured to connect respectively an anode of each of the top emission type of light-emitting units(400) to a respective pixel driving circuit(200).

## Patentansprüche

1. Organische-Elektrolumineszenz-Anzeigetafel, umfassend:
ein Grundsubstrat (100), das ein Anzeigegebiet (A) aufweist;
eine Gate-Ansteuerschaltung (300) und eine Vielzahl von Pixel-Ansteuerschaltungen (200), die sich in dem Anzeigegebiet (A) befinden;
eine Vielzahl von Datenleitungen in dem Anzeigegebiet (A); und
eine Vielzahl von obenemittierenden Leuchteinheiten (400), die sich in dem Anzeigegebiet (A) befinden, wobei
eine orthographische Projektion der Gate-Ansteuerschaltung (300) auf das Grundsubstrat (100) zumindest teilweise mit einer orthographischen Projektion der Vielzahl von obenemittierenden Leuchteinheiten (400) auf das Grundsubstrat (100) überlappt,
**dadurch gekennzeichnet, dass** jede der mindestens einigen aus der Vielzahl von Pixel-Ansteuerschaltungen (200) ausgelegt ist zum Ansteuern von mindestens zwei obenemittierenden Leuchteinheiten (400) der Vielzahl von obenemittierenden Leuchteinheiten (400) und sich die Vielzahl von obenemittierenden Leuchteinheiten (400) über die Vielzahl von Datenleitungen spannt, so dass alle Schaltungen, die die Gate-Ansteuerschaltung (300) und die Vielzahl von Pixel-Ansteuerschaltungen (200) in dem Anzeigegebiet (A) umfassen, durch die Vielzahl von obenemittierenden Leuchteinheiten (400) abgedeckt werden.

2. Organische-Elektrolumineszenz-Anzeigetafel nach Anspruch 1, wobei
die orthogonale Projektion der Gate-Ansteuerschaltung (300) auf das Grundsubstrat (100) nicht mit einer orthogonalen Projektion der Vielzahl von Pixel-Ansteuerschaltungen (200) auf das Grundsubstrat (100) überlappt.

3. Organische-Elektrolumineszenz-Anzeigetafel nach Anspruch 1, wobei
sich die Gate-Ansteuerschaltung (300) an einem Rand des Anzeigegebiets (A) befindet.

4. Organische-Elektrolumineszenz-Anzeigetafel nach Anspruch 1, wobei
die Gate-Ansteuerschaltung (300) eine Gate-Unteransteuerschaltung, die sich an einem Rand des Anzeigegebiets befindet, umfasst.

5. Organische-Elektrolumineszenz-Anzeigetafel nach Anspruch 1, wobei
die Gate-Ansteuerschaltung (300) eine erste Gate-Unteransteuerschaltung und eine zweite Gate-Unteransteuerschaltung, die sich an zwei entgegengesetzten Rändern des Anzeigegebiets (A) befinden, umfasst.

6. Organische-Elektrolumineszenz-Anzeigetafel nach Anspruch 1, wobei
sich die Gate-Ansteuerschaltung (300) zwischen zwei angrenzenden Pixel-Ansteuerschaltungen (200) befindet.

7. Organische-Elektrolumineszenz-Anzeigetafel nach Anspruch 1, wobei
jede der obenemittierenden Leuchteinheiten (400) eine Anode, eine Leuchtschicht und eine Kathode, die sequenziell gestapelt sind, umfasst, wobei die Anode mit einer jeweiligen Ansteuerschaltung (200) verbunden ist.

8. Organische-Elektrolumineszenz-Anzeigetafel nach Anspruch 7, wobei
die Anode von jeder der obenemittierenden Leuchteinheiten (400) mit der jeweiligen Pixel-Ansteuerschaltung (200) über eine Verbindungsleitung (500) verbunden ist.

9. Organische-Elektrolumineszenz-Anzeigetafel nach Anspruch 8, wobei
sich die Verbindungsleitung (500) zwischen einer ersten Filmschicht, in der sich die jeweilige obenemittierende Leuchteinheit (400) befindet, und einer zweiten Filmschicht, in der sich die jeweilige Pixel-Ansteuerschaltung (200) befindet, befindet.

10. Anzeigevorrichtung, die die Organische-Elektrolumineszenz-Anzeigetafel nach einem der Ansprüche 1-9 umfasst.

11. Verfahren zum Herstellen der Organische-Elektrolumineszenz-Anzeigetafel nach einem der Ansprüche 1-9, umfassend:
Herstellen einer Gate-Ansteuerschaltung (300) und einer Vielzahl von Pixel-Ansteuerschaltungen (200) in einem Anzeigegebiet (A) eines Grundsubstrats (100), wobei eine orthogonale Projektion der Gate-Ansteuerschaltung (300) auf das Grundsubstrat (100) nicht mit einer orthogonalen Projektion der Vielzahl von Pixel-Ansteuerschaltungen (200) auf das Grundsubstrat (100) überlappt; und
weiteres Herstellen einer Vielzahl von obenemittierenden Leuchteinheiten (400) in dem Anzeigegebiet (A), wobei die Vielzahl von obenemittierenden Leuchteinheiten (400) zumindest teilweise die Vielzahl von Pixelschaltungen (200) und die Gate-Ansteuerschaltung (300) abdeckt, und die orthographische Projektion der Gate-Ansteuerschaltung (300) auf das Grundsubstrat (100) zumindest teilweise mit einer orthographischen Projektion der Vielzahl von obenemittierenden Leuchteinheiten (400) auf das Grundsubstrat (100) überlappt.

12. Herstellungsverfahren nach Anspruch 11, ferner umfassend:
nach Herstellen der Gate-Ansteuerschaltung (300) und der Vielzahl von Pixel-Ansteuerschaltungen (200) in dem Anzeigegebiet (A) des Grundsubstrats (100), und vor dem weiteren Herstellen der Vielzahl von obenemittierenden Leuchteinheiten (400) in dem Anzeigegebiet (A), Herstellen von Verbindungsleitungen (500), wobei die Verbindungsleitungen (500) ausgelegt sind zum jeweiligen Verbinden einer Anode von jeder der obenemittierenden Leuchteinheiten (400) mit einer jeweiligen Pixel-Ansteuerschaltung (200).

## Revendications

1. Panneau d'affichage électroluminescent organique, comprenant :
un substrat de base (100) présentant une zone d'affichage (A) ;
un circuit de commande de grille (300) et une pluralité de circuits de commande de pixels (200) situés dans la zone d'affichage (A) ;
une pluralité de lignes de données dans la zone d'affichage (A) ; et
une pluralité d'unités électroluminescentes du type à émission par le haut (400) situées dans la zone d'affichage (A), dans lequel
une projection orthographique du circuit de commande de grille (300) sur le substrat de base (100) chevauche au moins partiellement une projection orthographique de la pluralité d'unités électroluminescentes du type émission par le haut (400) sur le substrat de base (100),
**caractérisé en ce que** chaque circuit d'au moins certains de la pluralité de circuits de commande de pixels (200) est configuré pour commander au moins deux unités électroluminescentes du type à émission par le haut (400) de la pluralité d'unités électroluminescentes du type à émission par le haut (400), et la pluralité d'unités électroluminescentes du type à émission par le haut (400) s'étend sur la pluralité de lignes de données, de telle sorte que tous les circuits comprenant le circuit de commande de grille (300) et la pluralité de circuits de commande de pixels (200) dans la zone d'affichage (A) soient couverts par la pluralité d'unités électroluminescentes du type à émission par le haut (400).

2. Panneau d'affichage électroluminescent organique selon la revendication 1, dans lequel
la projection orthogonale du circuit de commande de grille (300) sur le substrat de base (100) ne chevauche pas une projection orthogonale de la pluralité de circuits de commande de pixels (200) sur le substrat de base (100).

3. Panneau d'affichage électroluminescent organique selon la revendication 1, dans lequel
le circuit de commande de grille (300) est situé au niveau d'un bord de la zone d'affichage (A).

4. Panneau d'affichage électroluminescent organique selon la revendication 1, dans lequel
le circuit de commande de grille (300) comprend un sous-circuit de commande de grille situé au niveau d'un bord de la zone d'affichage.

5. Panneau d'affichage électroluminescent organique selon la revendication 1, dans lequel
le circuit de commande de grille (300) comprend un premier sous-circuit de commande de grille et un second sous-circuit de commande de grille situés respectivement au niveau de deux bords opposés de la zone d'affichage (A).

6. Panneau d'affichage électroluminescent organique selon la revendication 1, dans lequel
le circuit de commande de grille (300) est situé entre deux circuits de commande de pixels (200) adjacents.

7. Panneau d'affichage électroluminescent organique selon la revendication 1, dans lequel
chacune des unités électroluminescentes du type émission par le haut (400) comprend une anode, une couche électroluminescente et une cathode qui sont empilées de manière séquentielle, dans lequel l'anode est connectée à un circuit de commande de pixels (200) respectif.

8. Panneau d'affichage électroluminescent organique selon la revendication 7, dans lequel
l'anode de chacune des unités électroluminescentes du type à émission par le haut (400) est connectée aux circuits de commande de pixels (200) respectifs par une ligne de connexion (500).

9. Panneau d'affichage électroluminescent organique selon la revendication 8, dans lequel
la ligne de connexion (500) est située entre une première couche de film où se trouve l'unité électroluminescente du type à émission par le haut (400) respective et une seconde couche de film où se trouve le circuit de commande de pixels (200) respectif.

10. Dispositif d'affichage comprenant le panneau d'affichage électroluminescent organique selon l'une quelconque des revendications 1 à 9.

11. Procédé de fabrication du panneau d'affichage électroluminescent organique selon l'une quelconque des revendications 1 à 9, comprenant :
la fabrication d'un circuit de commande de grille (300) et d'une pluralité de circuits de commande de pixels (200) dans une zone d'affichage (A) d'un substrat de base (100), dans lequel une projection orthogonale du circuit de commande de grille (300) sur le substrat de base (100) ne chevauche pas une projection orthogonale de la pluralité de circuits de commande de pixels (200) sur le substrat de base (100) ; et
la fabrication supplémentaire d'une pluralité d'unités électroluminescentes du type à émission par le haut (400) dans la zone d'affichage (A), dans lequel la pluralité d'unités électroluminescentes du type à émission par le haut (400) couvre au moins partiellement la pluralité de circuits de commande de pixels (200) et le circuit de commande de grille (300), et la projection orthographique du circuit de commande de grille (300) sur le substrat de base (100) chevauche au moins partiellement une projection orthographique de la pluralité d'unités électroluminescentes du type à émission par le haut (400) sur le substrat de base (100).

12. Procédé de fabrication selon la revendication 11, comprenant en outre :
après la fabrication du circuit de commande de grille (300) et de la pluralité de circuits de commande de pixels (200) dans la zone d'affichage (A) du substrat de base (100), et avant la fabrication supplémentaire de la pluralité d'unités électroluminescentes du type à émission par le haut (400) dans la zone d'affichage (A), la fabrication de lignes de connexion (500), dans lequel les lignes de connexion (500) sont configurées pour connecter respectivement une anode de chacune des unités électroluminescentes du type à émission par le haut (400) à un circuit de commande de pixels (200) respectif.
